# FASCICULE DE BREVET EUROPEEN

(11) **EP 1 645 015 B1**
(45) Date de publication et mention de la délivrance du brevet: **21.03.2018**
(21) Numéro de dépôt: 04767723.2
(22) Date de dépôt: 16.07.2004
(51) Int. Cl.: H01R 12/52, H05K 3/40, H01R 31/08, H05K 3/34

(54) **COMPOSANT, CIRCUIT IMPRIME DOUBLE FACE ET PROCEDE POUR REALISER UNE CONNEXION ELECTRIQUE D UN CIRCUIT IMPRIME DOUBLE FACE**
BAUELEMENT, DOPPELSEITIGE LEITERPLATTE UND VERFAHREN FÜR DIE ELEKTRISCHE VERBINDUNG EINER DOPPELSEITIGEN LEITERPLATTE
COMPONENT, DOUBLE-SIDED PRINTED CIRCUIT BOARD AND METHOD FOR MAKING AN ELECTRICAL CONNECTION OF A DOUBLE-SIDED PRINTED CIRCUIT

(30) Priorité: 16.07.2003 FR 0308697
(43) Date de publication de la demande: 12.04.2006
(73) Titulaire: Groupe Brandt, 92500 Rueil-Malmaison (FR)
(72) Inventeur: CORNEC, René, F-85300 Challan (FR); FOURNIER, Dominique, F-45750 St Pryve St Mesmin (FR); MARLIOT, Eric, F-41220 La Ferte St Cyr (FR)
(74) Mandataire: Santarelli
(86) Numéro de dépôt international: PCT/FR2004/001899
(87) Numéro de publication internationale: WO 2005/008842

(56) Documents cités:
- DE-A- 3 521 752
- DE-A- 3 624 412
- DE-A1- 3 521 752
- DE-C1- 19 625 934
- FR-A- 1 299 039
- US-A- 2 966 652
- US-A- 2 966 652
- US-A- 3 319 317
- US-A- 4 592 137
- US-A- 4 592 137
- US-B1- 6 333 471
- US-B1- 6 333 471

## Description

La présente invention concerne un composant pour circuit imprimé double face et un circuit imprimé double face.

Elle concerne également un procédé de réalisation d'une connexion électrique entre deux pistes conductrices d'un circuit imprimé double face.

Les circuits imprimés sont utilisés de manière usuelle pour assembler et interconnecter des composants électroniques entre eux.

La présente invention concerne plus précisément les circuits imprimés double face, qui sont constitués d'un support comportant sur deux faces opposées des pistes conductrices, généralement en cuivre.

De manière usuelle le support est percé de trous traversants permettant d'insérer les pattes de composants électroniques. Ces composants sont ainsi des composants montés à piquer.

La première face du support sur laquelle sont situés les composants est généralement appelée côté composant.

Cette première face est destinée à recevoir des composants montés à piquer et des composants montés en surface (CMS).

La seconde face du support où apparaissent les pattes des composants est appelée côté soudure ou côté vague. En effet, les composants sont traditionnellement soudés sur cette face du support via des bains d'étain à la vague.

Il est parfois nécessaire dans ce type de circuit double face de réaliser des connexions entre des pistes conductrices situées respectivement sur chaque face du support.

A cet effet, certains trous traversants, venant en contact avec les pistes conductrices de part et d'autre du support, peuvent être métallisés, généralement par électrolyse.

Cependant, de manière économique, les circuits imprimés sont réalisés de plus en plus en utilisant une technique d'estampillage, automatisable et économique, pour créer et détourer les trous traversants dans le support.

Cependant, cette technique d'estampillage présente l'inconvénient de ne pas permettre la métallisation des trous par électrolyse du fait de la présence des pistes de cuivre réalisées avant estampillage.

Une autre méthode connue pour métalliser les trous consiste à remplir ces derniers d'une pâte conductrice à base d'argent déposée par sérigraphie.

Cette technique est cependant coûteuse et ne permet pas le passage d'un courant d'intensité élevée du fait de la résistivité de la pâte conductrice.

On connaît également un procédé de réalisation d'une interconnexion entre des pistes conductrices d'un circuit tel que décrit dans le document EP 0 126 164.

Un fil conducteur de l'électricité, doté d'un grain de soudure, est inséré dans un trou traversant du support. Lors de l'étape de soudage, ce fil est soudé côté soudure du support. Par transmission de la chaleur, via le fil conducteur, on observe une fonte du grain de soudure à bas point de fusion, de telle sorte que la connexion est également réalisée au niveau du côté composant du support.

Cependant, cette technique présente de nombreux inconvénients. En effet, afin de transmettre la chaleur via le fil conducteur nécessaire à la fonte de la soudure basse température, ce fil doit être court. L'introduction de ce fil dans un trou traversant du circuit imprimé est alors difficilement automatisable.

En outre, la présence d'un grain de soudure sur ce fil rend sa manipulation délicate, au risque de détériorer ce grain de soudure, et de rendre inopérant le procédé de connexion ultérieur.

De plus, la distance séparant ce grain de soudure de la face du support est difficilement maîtrisable, de telle sorte que cette distance peut être très élevée. Dans ce cas, le grain de soudure fondu peut ne pas venir en contact avec le support, ou au contraire tomber sur le support et ne plus être en contact avec le fil, de telle sorte que la connexion électrique n'est pas obtenue.

On connaît aussi par le document US 2 966 652 un composant ayant quatre bras, deux de ces bras étant adaptés à traverser un trou traversant du circuit imprimé. Le maintien en place du composant dans ce trou doit être réalisé par le pliage des bras.

Le document DE 35 21 752 décrit également un composant pour circuit imprimé pour réaliser une connexion électrique entre deux pistes conductrices disposées sur deux faces opposées du circuit imprimé. Ce composant est composé d'un fil métallique recourbé à ses extrémités.

On connait également par le document DE 196 25 934 un composant pour circuit imprimé avec une portion plane pour la manipulation du composant au moyen d'une buse aspirante.

La présente invention a pour but de résoudre les inconvénients précités et de proposer, un circuit imprimé et un procédé permettant la connexion de pistes conductrices situées sur des faces opposées d'un tel circuit tels que définis dans les revendications.

Un composant pour circuit imprimé double face à trous traversants non métallisés est constitué d'une pièce en matériau électriquement conducteur ayant deux pattes allongées adaptées à traverser respectivement deux trous dudit circuit imprimé.

Les deux pattes allongées sont solidaires d'une portion élargie plate s'étendant perpendiculairement aux pattes allongées.

Grâce à sa forme spécifique, la manipulation de ce composant de connexion électrique peut être réalisée aisément, de la même manière qu'un composant classique monté en surface (CMS).

En particulier, la portion élargie plate permet une manipulation du composant au moyen d'une buse aspirante.

En outre, cette portion élargie plate, adaptée à s'étendre parallèlement au plan du support du circuit imprimé, peut être fixée au moyen d'une brasure directement sur une face de ce support.

Le maintien du composant est en outre assuré grâce aux deux pattes montées dans deux trous distincts du circuit imprimé.

De préférence, ce composant a une forme de U ayant deux pattes allongées disposées symétriquement par rapport à ladite portion élargie plate.

Cette disposition symétrique de pattes allongées permet d'obtenir un montage fiable du composant sur un circuit imprimé, assurant un bon ancrage de celui-ci sur le support.

Selon un aspect de l'invention, elle concerne un procédé de réalisation d'une connexion électrique entre deux pistes conductrices disposées respectivement sur deux faces d'un circuit imprimé à trous traversants non métallisés.

Ce procédé comprend les étapes suivantes :
- dépôt d'une brasure sur une portion de piste conductrice d'une première face du circuit imprimé ;
- insertion d'un composant constitué d'une pièce en matériau électriquement conducteur ayant deux pattes allongées solidaires d'une portion élargie plate s'étendant perpendiculairement aux pattes allongées, les deux pattes allongées traversant respectivement deux trous du circuit imprimé et la portion élargie plate venant en contact avec ladite portion de piste conductrice recouverte de brasure ; et
- brasage dudit composant sur la portion de piste conductrice.

Le dépôt d'une brasure, l'insertion du composant et la fixation par brasage du composant peuvent être réalisés simultanément au montage des autres composants sur le côté composant du circuit imprimé.

Ainsi, la réalisation de l'interconnexion entre deux pistes conductrices du circuit imprimé peut être réalisée lors du procédé standard de montage des composants.

En outre, ce composant étant fixé côté composant du circuit imprimé, la manipulation de ce dernier est facilitée et notamment son retournement pour effectuer des opérations côté soudure.

La présente invention concerne également un circuit imprimé double face à trous traversants non métallisés.

Ce circuit comprend au moins un composant constitué d'une pièce en matériau électriquement conducteur ayant deux pattes allongées solidaires d'une portion élargie plate s'étendant perpendiculairement aux pattes allongées, les deux pattes allongées traversant respectivement deux trous du circuit imprimé et la portion élargie plate étant fixée par brasage sur une portion de piste conductrice d'une première face du circuit imprimé.

D'autres particularités et avantages de l'invention paraîtront encore dans la description ci-après.

Aux dessins annexés, donnés à titre d'exemples non limitatifs :
- la figure 1 est une vue en perspective d'un composant pour circuit imprimé conforme à un mode de réalisation de l'invention ;
- la figure 2 est une vue de dessus du composant déplié de la figure 1 ;
- la figure 3 est une vue de dessus du composant de la figure 1 ;
- les figures 4a, 4b, 4c, et 4d illustrent les différentes étapes du procédé de réalisation d'une connexion électrique conforme à l'invention ; et
- la figure 5 illustre un principe de manipulation du composant de la figure 1.

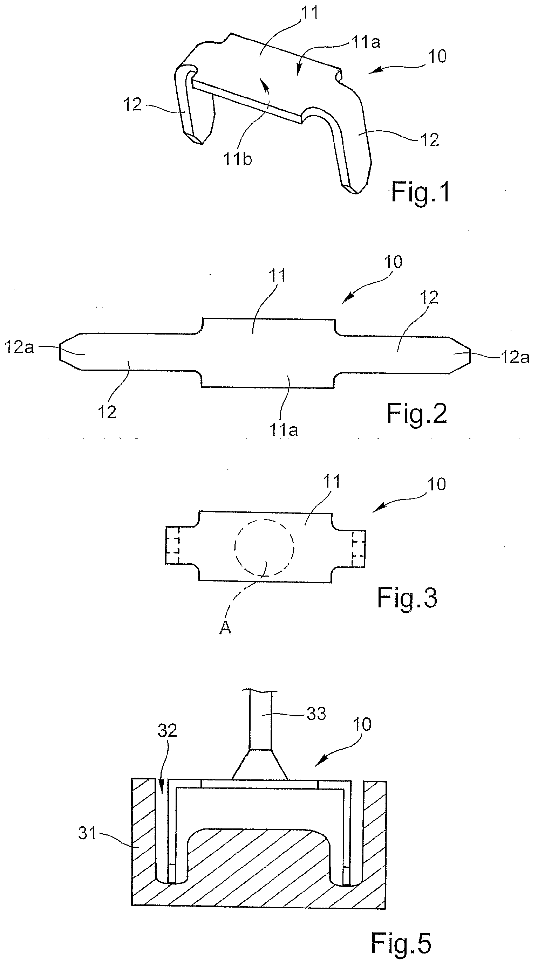

On va décrire tout d'abord en référence aux figures 1 à 3 un composant destiné à être monté en surface d'un circuit imprimé, et permettant de réaliser une connexion électrique entre des pistes conductrices disposées sur deux faces opposées d'un circuit imprimé.

Dans ce mode de réalisation, le composant 10 a une forme sensiblement de U.

Une portion plate élargie constitue ainsi la base de cette forme en U. Cette portion plate élargie 11 est prolongée symétriquement par des pattes allongées 12.

Dans ce mode de réalisation, la portion plate élargie 11 a une forme sensiblement rectangulaire.

Les pattes allongées 12 s'étendent ainsi sur les deux petits côtés 11 a de cette portion rectangulaire 11.

Comme bien illustré à la figure 2, ce composant peut être réalisé par découpe d'une forme dans une feuille de métal conducteur.

Comme illustré à la figure 3, les pattes allongées 12 sont ensuite repliées de part et d'autre de la portion élargie 11.

A titre d'exemple non limitatif, ce composant 10 peut être réalisé en bronze CUE9P.

En fonction de l'épaisseur et de la nature du métal utilisé, le courant électrique transmissible par ce composant peut être très important, et notamment plus important que celui transmissible dans un trou métallisé via une pâte à base d'argent utilisée traditionnellement dans les circuits imprimés.

Comme bien illustré à la figure 2, les extrémités terminales 12a des pattes allongées sont de préférence effilées, afin de faciliter l'introduction de ces pattes allongées 12 dans des trous traversants d'un circuit imprimé comme décrit ultérieurement.

Comme bien illustré à la figure 3, la portion élargie 11 présente une portion centrale A de dimensions et de planéité suffisantes pour permettre une fixation fiable du composant sur un circuit imprimé.

Afin de faciliter la manipulation de ce composant 10 et son accrochage ultérieur à un circuit imprimé, il est important que la portion plate élargie 11 possède une bonne planéité tant sur sa surface extérieure 11a que sur sa surface intérieure 11b.

A titre d'exemple, la planéité de la surface extérieure 11a est de l'ordre de 5 µm, alors que la planéité de la surface inférieure 11b doit atteindre au moins 20 µm.

Ces distances correspondent à l'écart maximal pouvant exister entre le point le plus haut et le point le plus bas de la surface.

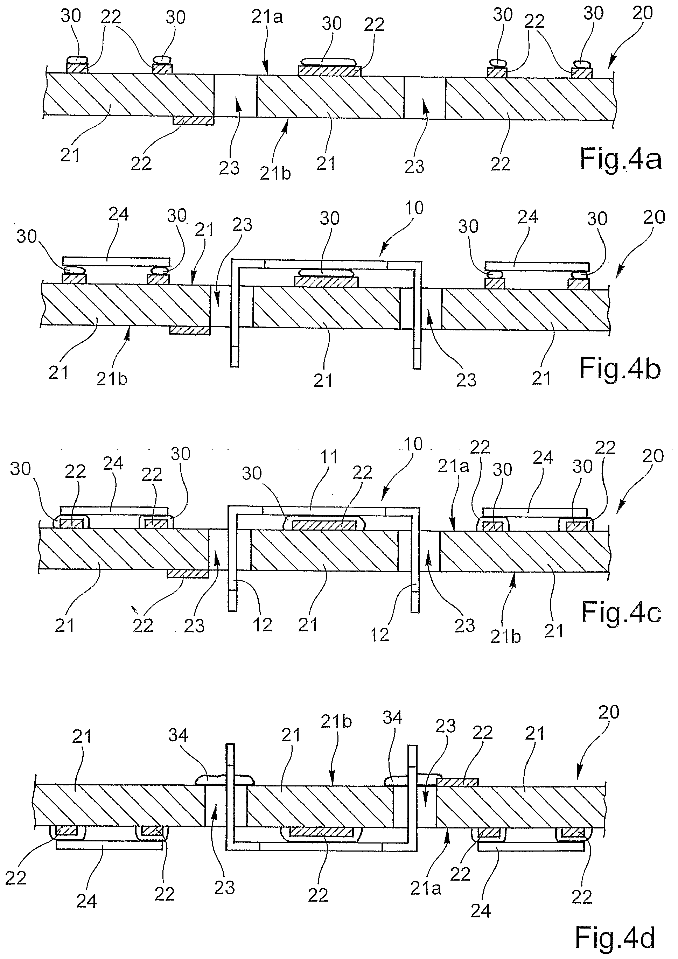

On va décrire à présent en référence aux figures 4a à 4d un procédé de réalisation d'une connexion électrique dans un circuit imprimé.

Comme bien illustré à la figure 4a, un circuit imprimé 20 est constitué d'un support 21 en matériau isolant, et par exemple en époxy.

Il s'agit ici d'un circuit imprimé double face comportant des pistes de cuivre 22 permettant de réaliser la connexion de différents composants électroniques.

Usuellement, la première face 21a du support 21, comportant l'essentiel des pistes de cuivre 22 et sur laquelle sont destinés à être placé les composants électroniques, est appelée côté composant 21a.

La seconde face 21b du support, comprenant également des pistes de cuivre 22, est appelée côté soudure.

Le support 21 est en outre percé de trous traversants 23 permettant l'introduction des pattes des composants électroniques à monter sur ce circuit imprimé.

Ce circuit imprimé 20 peut être réalisé à partir d'une technique d'estampillage.

En pratique, un procédé d'estampillage permet de créer les trous 23 dans le support 21.

Ensuite, les pistes conductrices 22 sont réalisées de chaque côté du support 21 par attaque chimique, par exemple par trempage du circuit imprimé 20 dans un bain de perchlorure de fer.

Conformément à l'invention, le procédé comporte ensuite une étape de dépôt d'une brasure 30 notamment sur des portions de pistes conductrices 22.

Ce dépôt de brasure est ainsi réalisé sur la face composant 21a du support 21.

Il peut être réalisé en utilisant des techniques habituelles de dépôt par sérigraphie d'une brasure. Cette brasure peut être constituée d'un mélange de plomb et d'étain.

Comme illustré à la figure 4b, le procédé comporte ensuite une étape d'insertion d'un composant 10 tel que décrit précédemment.

Ce composant 10 est inséré sur le circuit imprimé de telle sorte que les pattes allongées 12 traversent respectivement deux trous 23 du support 21.

La portion élargie plate 11 vient ainsi en contact avec une portion de piste conductrice 22 recouverte de brasure 30.

Les pattes allongées 12, de la portion élargie plate 21 aux extrémités 12a, s'étendent ainsi parallèlement à la direction des trous traversants 23, c'est-à-dire perpendiculairement au plan du circuit imprimé 20.

L'insertion de ce composant 10 peut être réalisée simultanément au dépôt des autres composants montés en surface (CMS) 24.

Comme bien illustré à la figure 5, le composant 10 conforme à l'invention peut être disposé en bande dans des alvéoles 32. Les bandes d'alvéoles 32 logeant les composants 10 peuvent se présenter sous la forme de rouleaux.

Cette technique de présentation du composant 10 est identique à celle utilisée classiquement pour d'autres composants CMS, de telle sorte qu'elle peut être intégrée aux machines de pose utilisées traditionnellement pour déposer des composants sur un circuit imprimé.

En pratique, le composant 10 est pris dans son alvéole 32 par une buse aspirante 33 existant de manière traditionnelle sur les machines de pose de composant CMS.

Afin de permettre le transfert et la manipulation de ce composant 10 à l'aide de la buse aspirante 33, il est important que la surface extérieure 11a de ce composant 10 soit d'une parfaite planéité comme décrit précédemment.

Une fois le composant 10 inséré dans le circuit imprimé 20, une étape de brasage telle qu'illustrée à la figure 4c permet de fixer ce composant 10, ainsi que les autres composants 24, sur les pistes conductrices 22. En pratique, le circuit imprimé tel qu'illustré à la figure 4b est introduit dans un four de refusion de telle sorte que la brasure fond et permet une fixation de la face inférieure 11b du composant 10 sur la piste conductrice 22, du côté de la première face 21a du support 21.

Grâce à cette étape de brasage, le circuit imprimé 20 peut ensuite être retourné et manipulé, notamment pour effectuer des opérations côté soudure 21b du support 21.

Une étape de soudage est ensuite mise en oeuvre sur cette seconde face 21b du circuit imprimé 20 afin de souder à l'aide d'un matériau de soudure 34 les pattes allongées 12b au niveau de la seconde face 21b du support 21.

Le soudage de ces pattes 12 peut être réalisé grâce à un procédé usuel de soudage à la vague, simultanément au soudage des autres composants CMS (non représentés).

Cette étape de soudage permet ainsi comme illustré à la figure 4d de réaliser une connexion électrique entre une patte allongée 12 du composant 10 et une piste résistive 22 disposée sur la face de soudure 21b du support 21.

Le soudage est réalisé au niveau de chaque patte allongée 12 débouchant des trous traversants 23.

Ainsi, une connexion électrique peut être réalisée entre les pistes conductrices 22 situées de part et d'autre du support 21.

Bien entendu, de nombreuses modifications peuvent être apportées aux exemples de réalisation décrits précédemment sans sortir du cadre de l'invention.

## Revendications

1. Procédé de réalisation d'une connexion électrique entre deux pistes conductrices (22) disposées respectivement sur deux faces (21a, 21b) d'un circuit imprimé (20) à trous traversants non métallisés (23), **caractérisé en ce qu'**il comprend les étapes suivantes :
- dépôt d'une brasure (30) sur une portion de piste conductrice (22) d'une première face (21a) du circuit imprimé (20);
- insertion d'un composant (10) constitué d'une pièce en matériau électriquement conducteur ayant deux pattes allongées (12) solidaires d'une portion élargie plate (11) s'étendant perpendiculairement aux pattes allongées (12), lesdites deux pattes allongées (12) traversant respectivement deux trous (23) du circuit imprimé (20) et ladite portion élargie plate (11) venant en contact avec ladite portion de piste conductrice (22) recouverte de brasure (30) ; et
- brasage dudit composant (10) sur la portion de piste conductrice (22).

2. Procédé de réalisation d'une connexion électrique conforme à la revendication 1, **caractérisé en ce que** ladite portion élargie plate (11) du composant (10) est placée sur une première face (21a) du circuit imprimé (20) adaptée à supporter les composants (24) montés en surface du circuit imprimé (20).

3. Procédé de réalisation d'une connexion électrique conforme à l'une des revendications 1 ou 2, **caractérisé en ce qu'**il comprend en outre une étape de soudage sur une seconde face (21b) du circuit imprimé (20) des pattes allongées (12) du composant (10) insérées respectivement dans les trous traversants (23) dudit circuit imprimé (20).

4. Circuit imprimé double face à trous traversants non métallisés, où il comprend au moins un composant constitué d'une pièce (10) en matériau électriquement conducteur ayant deux pattes allongées (12) solidaires d'une portion élargie plate (11) s'étendant perpendiculairement au pattes allongées (12), **caracterisé en ce que** lesdites deux pattes allongées (12) traversant respectivement deux trous (23) dudit circuit imprimé (20) et ladite portion élargie plate (11) étant fixée par brasage sur une portion de piste conductrice (22) d'une première face (21a) dudit circuit imprimé (20).

5. Circuit imprimé double face conforme à la revendication 4, **caractérisé en ce que** ledit composant a une forme de U, les deux pattes allongées (12) étant disposées symétriquement par rapport à ladite portion élargie plate (11).

6. Circuit imprimé double face conforme à l'une des revendications 4 ou 5, **caractérisé en ce que** la portion élargie plate (11) dudit composant a une forme sensiblement rectangulaire.

## Patentansprüche

1. Verfahren zum Herstellen einer elektrischen Verbindung zwischen zwei Leiterbahnen (22), die an zwei jeweiligen Seiten (21a, 21b) einer gedruckten Schaltung (20) mit nicht metallisierten Durchgangslöchern (23) angeordnet sind, **dadurch gekennzeichnet, dass** es folgende Schritte umfasst:
- Aufbringen einer Lötnaht (30) auf einen Abschnitt der Leiterbahn (22) einer ersten Seite (21a) der gedruckten Schaltung (20);
- Einsetzen einer Komponente (10), die aus einem Teil aus elektrisch leitendem Material mit zwei langgestreckten Schenkeln (12) besteht, die fest mit einem flachen Erweiterungsabschnitt (11) verbunden sind, der sich senkrecht zu den langgestreckten Schenkeln (12) erstreckt, wobei die beiden langgestreckten Schenkel (12) zwei jeweilige Löcher (23) der gedruckten Schaltung (20) durchsetzen und der flache Erweiterungsabschnitt (11) den mit der Lötnaht (30) überdeckten Abschnitt der Leiterbahn (22) kontaktiert; und
- Verlöten der Komponente (10) an dem Abschnitt der Leiterbahn (22).

2. Verfahren zum Herstellen einer elektrischen Verbindung nach Anspruch 1, **dadurch gekennzeichnet, dass** der flache Erweiterungsabschnitt (11) der Komponente (10) an einer ersten Seite (21a) der gedruckten Schaltung (20) angeordnet ist, die dazu ausgelegt ist, die oberflächenmontierten Komponenten (24) der gedruckten Schaltung (20) zu tragen.

3. Verfahren zum Herstellen einer elektrischen Verbindung nach einem der Ansprüche 1 oder 2, **dadurch gekennzeichnet, dass** es ferner einen Schritt des Verschweißens der in die jeweiligen Durchgangslöcher (23) der gedruckten Schaltung (20) eingesetzten langgestreckten Schenkel (12) der Komponente (10) auf einer zweiten Seite (21b) der gedruckten Schaltung (20) umfasst.

4. Doppelseitige gedruckte Schaltung mit nicht metallisierten Durchgangslöchern, wobei sie zumindest eine Komponente enthält, die aus einem Teil (10) aus elektrisch leitendem Material mit zwei langgestreckten Schenkeln (12) besteht, die fest mit einem flachen Erweiterungsabschnitt (11) verbunden sind, der sich senkrecht zu den langgestreckten Schenkeln (12) erstreckt,
**dadurch gekennzeichnet, dass** die beiden langgestreckten Schenkel (12) zwei jeweilige Löcher (23) der gedruckten Schaltung (20) durchsetzen und der flache Erweiterungsabschnitt (11) durch Verlöten an einen Abschnitt der Leiterbahn (22) einer ersten Seite (21a) der gedruckten Schaltung (20) befestigt ist.

5. Doppelseitige gedruckte Schaltung nach Anspruch 4, **dadurch gekennzeichnet, dass** die Komponente eine U-Form hat, wobei die beiden langgestreckten Schenkel (12) symmetrisch zum flachen Erweiterungsabschnitt (11) angeordnet sind.

6. Doppelseitige gedruckte Schaltung nach einem der Ansprüche 4 oder 5, **dadurch gekennzeichnet, dass** der flache Erweiterungsabschnitt (11) der Komponente eine im Wesentlichen rechteckige Form hat.

## Claims

1. Method for producing an electrical connection between two conductive tracks (22) disposed respectively on two faces (21a, 21b) of a printed circuit (20) with non-metallised through holes (23), **characterised in that** it comprises the following steps:
- depositing solder (30) on a portion of conductive track (22) of a first face (21a) of the printed circuit (20);
- inserting a component (10) consisting of a part made from electrically conductive material having two elongate lugs (12) secured to a flat broadened portion (11) extending perpendicular to the elongate lugs (12), said two elongate lugs (12) passing respectively through two holes (23) of the printed circuit (20) and said flat broadened portion (1) coming into contact with said portion of conductive track (22) covered with solder (30); and
- soldering said component (10) on the portion of conductive track (22).

2. Method for producing an electrical connection according to claim 1, **characterised in that** said flat broadened portion (11) of the component (10) is placed on a first face (21a) of the printed circuit (20) suitable for supporting the components (24) mounted on the surface of the printed circuit (20).

3. Method for producing an electrical connection according to either claim 1 or claim 2, **characterised in that** it further comprises a step of soldering, on a second face (21b) of the printed circuit (20), elongate lugs (12) of the component (10) inserted respectively in the through holes (23) of said printed circuit (20).

4. Double-sided printed circuit with non-metallised through holes, wherein it comprises at least one component consisting of a part (10) made from electrically conductive material having two elongate lugs (12) secured to a flat broadened portion (11) extending perpendicular to the elongate lugs (12), **characterised in that** said two elongate lugs (12) passing respectively through two holes (23) of said printed circuit (20) and said flat broadened portion (11) being fixed by soldering to a portion of conductive track (22) on a first face (21a) of said printed circuit (20).

5. Double-sided printed circuit according to claim 4, **characterised in that** said component is in a U shape, the two elongate lugs (12) being disposed symmetrically with respect to said flat broadened portion (11).

6. Double-sided printed circuit according to either claim 4 or claim 5, **characterised in that** the flat broadened portion (11) of said component has a substantially rectangular shape.
